# EUROPEAN PATENT APPLICATION

(11) **EP 4 319 519 A1**
(43) Date of publication of application: **07.02.2024**
(21) Application number: 22798817.7
(22) Date of filing: 28.02.2022
(51) Int. Cl.: H05K 7/20, F25D 17/02, H01L 23/473

(54) **COOLING APPARATUS**

(30) Priority: 07.05.2021 JP 2021078894
(71) Applicant: NEC Platforms, Ltd., Kanagawa 213-8511 (JP)
(72) Inventor: ISOYA Satoshi, Kawasaki-shi, Kanagawa 213-8511 (JP)
(74) Representative: Vossius & Partner Patentanwälte Rechtsanwälte mbB
(86) International application number: PCT/JP2022/008234
(87) International publication number: WO 2022/234710

(57) **Abstract**

One objective of the present invention is to provide a cooling apparatus or the like that can suppress an increase in the number of pipes. A cooling device according to one aspect of the present disclosure comprises: a first flexible pipe, at least a part of which is arranged inside a housing in which a plurality of modules is installed, each module including an electronic circuit board that includes a heat-generating member and a cooling member that receives heat from the heat-generating member and uses a heat medium to cool the heat-generating member, and through which the heat medium supplied from the outside of the housing passes; a second flexible pipe that supplies the heat medium from the first flexible pipe to the cooling member included in any one of the plurality of modules and to the cooling member included in any other module of the plurality of modules; and a branching member for branching the heat medium into the first flexible pipe and the second flexible pipe, wherein the branching member is provided together with the cooling members.

## Description

### Technical Field

The present disclosure relates to a technology of cooling a heat-generating member.

### Background Art

There is a technology of cooling an electronic component including a heat-generating member. For example, PTLs 1 and 2 disclose technologies of cooling a heat-generating member to be cooled by supplying a heat medium to a stack of the heat-generating member and the cooling member.

### Citation List

### Patent Literature

PTL 1: JP 2020-145317 A
PTL 2: JP 2019-097237 A

### Summary of Invention

### Technical Problem

A plurality of cooling targets may be installed in one device. In this case, in order to flexibly determine the arrangement of the cooling targets, a pipe for supplying a refrigerant to the cooling member may be a pipe using a highly flexible material such as rubber. Independently connecting to each cooling target the pipes for supplying a heat medium from the outside of the device may increase the number of pipes in the device. Increased number of pipes may compress the inside of the device. The compressed inside of the device may increase the temperature inside the device, for example. In addition, if a device is attempted to be configured to prevent the inside from being compressed, the device may become larger.

The technologies disclosed in PTLs 1 and 2 assume that the cooling target and the pipe for supplying to the cooling member are fixed. Therefore, PTLs 1 and 2 do not assume the above situation.

The present disclosure was accomplished in light of the above mentioned problems and one objective thereof is to provide a cooling apparatus or the like that may suppress an increase in the number of pipes. Solution to Problem

A cooling apparatus according to an aspect of the present disclosure includes: a first flexible pipe at least a part of which is arranged inside a housing and through which a heat medium supplied from an outside of the housing passes, the housing including a plurality of modules installed in the housing, each of the plurality of modules including an electronic circuit board including a heat-generating member and a cooling member that receives heat from the heat-generating member and cools the heat-generating member by using the heat medium; and a branching member that causes the heat medium to branch from the first flexible pipe into the cooling member and a second flexible pipe, the cooling member being included in any one of the plurality of modules, the second flexible pipe supplying the heat medium to the cooling member included in any other module of the plurality of modules.

### Advantageous Effects of Invention

According to the present disclosure, the increase in the number of pipes may be suppressed.

### Brief Description of Drawings

[Fig. 1] Fig. 1 is a plan view illustrating an example of a configuration of a cooling apparatus of a first example embodiment of the present disclosure.
[Fig. 2] Fig. 2 is a cross-sectional view illustrating an example of the configuration of the cooling apparatus of the first example embodiment of the present disclosure.
[Fig. 3] Fig. 3 is a plan view illustrating an example of a configuration of a cooling apparatus of a second example embodiment of the present disclosure.
[Fig. 4] Fig. 4 is a plan view illustrating an example of a configuration of a cooling apparatus of a modified example 1 of the present disclosure.
[Fig. 5] Fig. 5 is a perspective view illustrating an example of a configuration of an electronic device of a cooling apparatus of a third example embodiment of the present disclosure.
[Fig. 6] Fig. 6 is a plan view illustrating an example of a lower configuration of the electronic device of the third example embodiment of the present disclosure.
[Fig. 7] Fig. 7 is a plan view illustrating an example of an upper configuration of the electronic device of the third example embodiment of the present disclosure.

### Example Embodiments

Example embodiments of the present disclosure will be described below with reference to the drawings.

### <First Example Embodiment>

An overview of a cooling apparatus of a first example embodiment will be described.

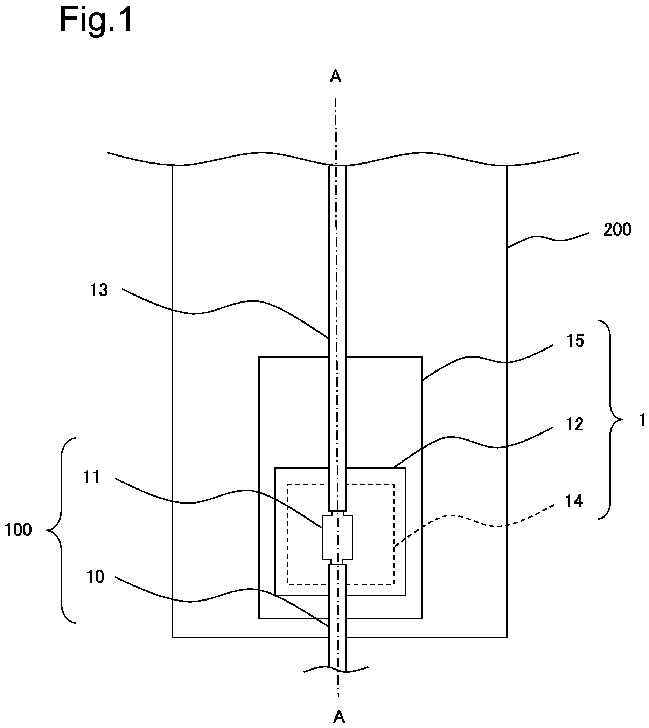

Fig. 1 is a plan view illustrating an example of a configuration of a cooling apparatus 100. As shown in Fig. 1, the cooling apparatus 100 includes a first flexible pipe 10 and a branching member 11.

A housing 200 includes a plurality of modules disposed in it. A module 1 shown in Fig. 1 is an example of a module disposed in a housing. The module 1 includes, for example, an electronic circuit board 15 including a heat-generating member 14, and a cooling member 12. The cooling member 12 is disposed on the heat-generating member 14. The cooling member 12 is a member that receives heat from the heat-generating member 14. The cooling member 12 is supplied with a heat medium from a branching member, and causes the heat medium to receive the heat received from the heat-generating member 14. The cooling member 12 may cool the heat-generating member 14 by using the heat medium as described above.

The heat medium passes through the inside of the first flexible pipe 10, the branching member 11, and a second flexible pipe 13. The first flexible pipe has a first end connected to the branching member 11. The first flexible pipe has a second end connected to, for example, a pump or radiator or the like that supplies the heat medium, although is not shown in Fig. 1. In addition, the second flexible pipe 13 has a first end connected to the branching member 11. The second flexible pipe 13 has a second end that is connected to, for example, any other module of the plurality of modules that is different from the module 1 or the like, although is not shown in Fig. 1. In the present disclosure, the flexible pipe is, for example, a pipe made of a highly flexible material such as ethyleme propylene diene monomer (EPDM) rubber. The flexible pipe is also referred to as a hose or tube.

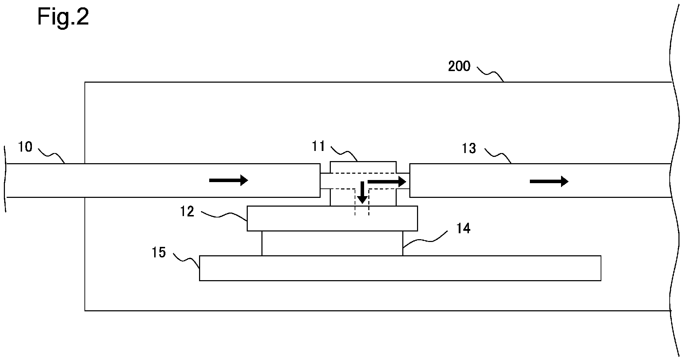

Fig. 2 is a cross-sectional view of an example of the configuration of the cooling apparatus 100. Specifically, Fig. 2 is a cross-sectional view taken along line A-A in Fig. 1. Arrows shown in Fig. 2 indicate directions in which the heat medium passes. For example, the heat medium supplied from the outside of the housing passes through the first flexible pipe 10 and is supplied to the branching member 11. The branching member 11 causes the heat medium supplied from the first flexible pipe 10 to branch into the cooling member 12 and the second flexible pipe 13. In other words, the second flexible pipe 13 supplies the heat medium flowing in from the branching member 11 to the cooling member included in any other module of the plurality of modules. At this time, the second flexible pipe 13 is supplied with a heat medium not directly affected by heat generation by the heat-generating member 14.

As described above, the cooling apparatus 100 of the first example embodiment includes, a first flexible pipe, at least a part of which is arranged inside a housing in which a plurality of modules is installed, each module including an electronic circuit board that includes a heat-generating member and a cooling member that receives heat from the heat-generating member and uses a heat medium to cool the heat-generating member, and through which the heat medium supplied from the outside of the housing passes, and a branching member that causes the heat medium from the first flexible pipe to branch into the cooling member included in any one of the plurality of modules and into a second flexible pipe that supplies the heat medium to the cooling member included in any other module of the plurality of modules, And the branching member is provided together with the cooling member. Thus, the cooling apparatus 100 may supply the heat medium to the cooling member of each module, without independently providing to each module a pipe that supplies the heat medium from the outside of the housing, for example. In other words, the cooling apparatus 100 of the first example embodiment may suppress the increase in the number of pipes. Additionally, the heat medium flowing into the second flexible pipe is not directly affected by heat generation by the heat-generating member. In other words, when supplying the heat medium from the second flexible pipe to the cooling members of other modules, the cooling apparatus 100 of the first example embodiment may also supply a heat medium with suppressed temperature rise to the cooling members of other modules.

### <Second Example Embodiment>

A cooling apparatus of a second example embodiment will now be described.

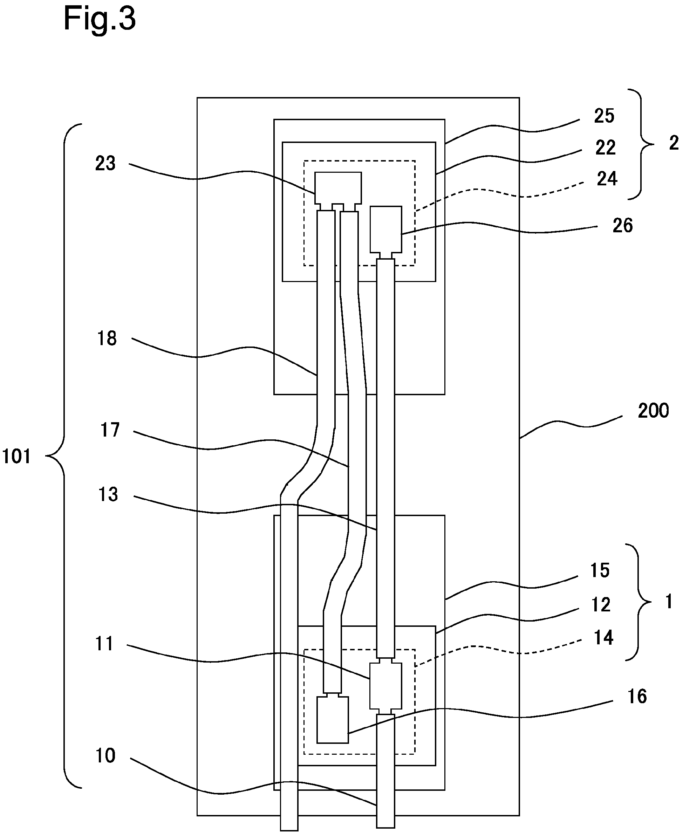

Fig. 3 is a plan view illustrating an example of a configuration of a cooling apparatus 101 of the second example embodiment. In the example of Fig. 3, a housing 200 is mounted with a module 1 and a module 2. The module 1 includes an electronic circuit board 15 including a heat-generating member 14, and a cooling member 12. The module 2 includes an electronic circuit board 25 including a heat-generating member 24, and a cooling member 22. The heat-generating members 14, 24 are, for example, a control processing unit (CPU) and a memory or the like, although are not limited to those examples. Like the cooling member 12, the cooling member 22 is a member that may cool the heat-generating member 24. In other words, the cooling member 22 is disposed on the heat-generating member 24, may cool the heat-generating member 24 by causing the heat medium to receive the heat received from the heat-generating member 24 heat. The cooling members 12, 22 may also be referred to as cold plates. In addition, in the present example embodiment, the cooling member 12 may be referred to as a first cooling member, and the cooling member 22 may be referred to as a second cooling member. The module 1 and module 2 may be cooled by the cooling member in the same manner, but may be different devices. In addition to the members shown in Fig. 3, another member may be mounted on the module 1 and module 2.

The cooling member 12 is provided with a branching member 11 and a connection joint 16. The connection joint 16 connects the cooling member 12 with a third flexible pipe 17. In other words, the heat medium discharged from the cooling member 12 passes through the connection joint 16 and flows into the third flexible pipe 17.

The cooling member 22 is provided with a connection joint 26 and a joining member 23. The connection joint 26 connects the cooling member 22 with the second flexible pipe 13. In other words, the heat medium flowing through the second flexible pipe 13 passes through the connection joint 26 and is supplied to the cooling member 22. The joining member 23 joins the heat medium discharged from the cooling member 12 provided together with the branching member 11 and the heat medium discharged from the cooling member 22. More specifically, the joining member 23 connects the cooling member 22, the third flexible pipe 17, and a fourth flexible pipe 18. In other words, the joining member 23 joins the heat medium discharged from the cooling member 22 and the heat medium flowing in from the third flexible pipe 17 and discharges the heat medium to the fourth flexible pipe 18.

Next, in the cooling apparatus 101 shown in Fig. 3, paths through which the heat medium passes will be sequentially described. The first flexible pipe 10 supplies a heat medium supplied from a pump or radiator or the like (not shown) outside the housing 200 to the branching member 11. The branching member 11 causes the heat medium to branch into the cooling member 12 and second flexible pipe 13. Here, for example, it is supposed that the heat medium is supplied to the first flexible pipe 10 at a flow rate of 2 L/min (liters per minute). In this case, for example, the branching member 11 supplies the heat medium to each of the cooling member 12 and second flexible pipe 13 at a flow rate of 1 L/min. In that case, the flexible pipes may have different pipe diameters according to the flow rate. For example, the first flexible pipe 10 may have a pipe diameter larger than the pipe diameter of the second flexible pipe 13.

The heat medium flowing through the cooling member 12 receives heat from the heat-generating member 14 and cooling member 12, passes through the connection joint 16 and third flexible pipe 17, and flows into the joining member 23. In addition, the heat medium supplied from the branching member 11 to the second flexible pipe 13 passes through the connection joint 26 and flows into the cooling member 22. The heat medium flowing through the cooling member 22 receives heat from the heat-generating member 24 and cooling member 22 and flows into the joining member 23. Then, the heat medium flows in from the joining member 23 into the fourth flexible pipe 18. The fourth flexible pipe 18 is connected to, for example, a radiator or the like outside the housing 200. In other words, the heat medium that receives heat in the housing 200 passes through the fourth flexible pipe 18 and is cooled by a radiator or the like. The cooled heat medium is supplied again to the first flexible pipe 10.

As described above, the cooling apparatus 101 of the second example embodiment includes, a first flexible pipe, at least a part of which is arranged inside a housing in which a plurality of modules is installed, each module including an electronic circuit board that includes a heat-generating member and a cooling member that receives heat from the heat-generating member and uses a heat medium to cool the heat-generating member, and through which the heat medium supplied from the outside of the housing passes, and a branching member for branching the heat medium from the first flexible pipe into the cooling member included in the module and a second flexible pipe. And the branching member is provided together with the cooling member. This provides the same effect as the cooling apparatus 100 of the first example embodiment.

In addition, the cooling apparatus 101 of the second example embodiment further includes a second flexible pipe, and a joining member that joins the heat medium discharged from the first cooling member that is a cooling member provided together with the branching member and the heat medium discharged from the second cooling member. In that case, the second cooling member is a cooling member included in other modules. With such a configuration, it is not necessary to discharge the heat medium discharged from each of the cooling members to the outside of the housing using an independent pipe. In other words, the increase in the number of pipes may be suppressed.

### [Modified Example 1]

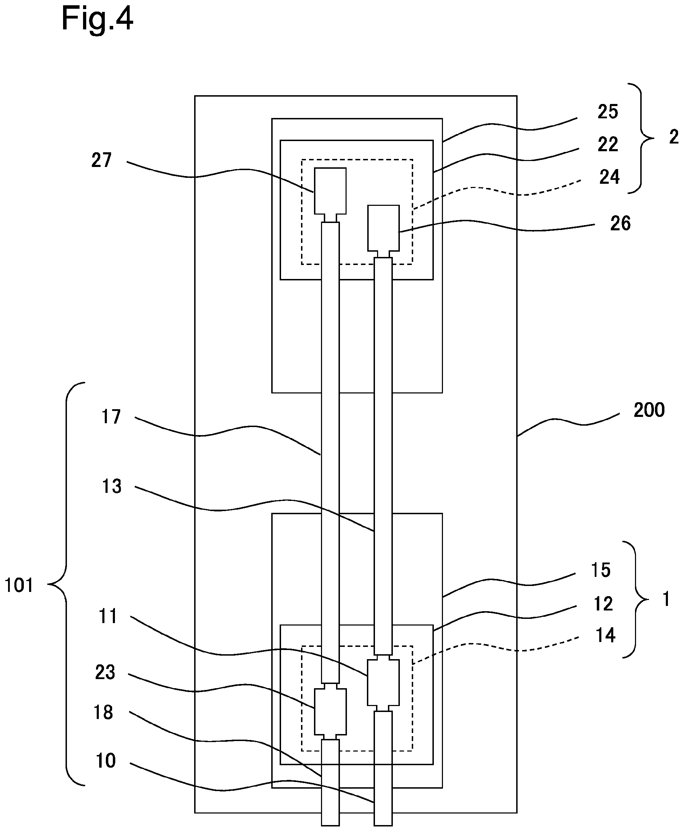

The cooling apparatus may be configured as shown in Fig. 4. Fig. 4 is a plan view illustrating an example of a configuration of a cooling apparatus 101 of a modified example 1. As shown in Fig. 4, the cooling member 12 is provided with the branching member 11 and the joining member 23. In addition, the cooling member 22 is provided with connection joints 26, 27.

In the modified example 1, the heat medium that passes through the cooling member 22 passes through the connection joint 27 and flows into the third flexible pipe 17. The joining member 23 joins the heat medium flowing in from the third flexible pipe and the heat medium discharged from the cooling member 12. Then, the heat medium discharged from the joining member 23 flows into the fourth flexible pipe 18.

As described above, in the cooling apparatus 101 of the modified example 1, the joining member is provided together with the first cooling member, and joins the heat medium flowing in from the third flexible pipe and the heat medium discharged from the first cooling member. At this time, the heat medium discharged from the second cooling member passes through the third flexible pipe. Such a configuration may suppress the compression by the pipes in the housing more than the cooling apparatus in Fig. 3.

### [Modified Example 2]

Although, in the second example embodiment, an example is described in which the housing 200 has two modules installed in it, the housing 200 may have three or more modules installed in it. For example, in the example of Fig. 3, the connection joint 26 may be replaced with a branching member, and the branching member may supply the heat medium to a cooling member included in a module different from the modules 1, 2. In this case, the cooling member and branching member are connected by a flexible pipe and a connection joint.

### <Third Example Embodiment>

A cooling apparatus of a third example embodiment will now be described. Some contents overlapping with the contents described in the first and second example embodiments will be omitted.

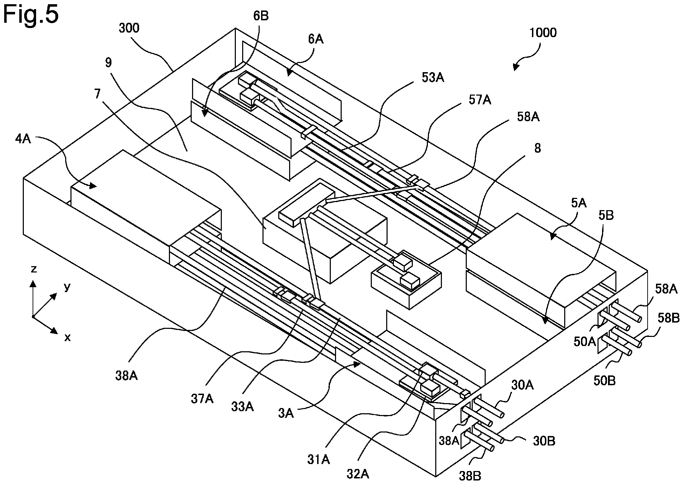

Fig. 5 is a perspective view illustrating an example of a configuration of an electronic device 1000 including a cooling apparatus 102 of the third example embodiment. The electronic device 1000 may be, for example, a server. In addition, for example, a plurality of electronic devices 1000 may be contained in a server rack (not shown), and the plurality of electronic devices 1000 may operate as a set of servers.

The electronic device 1000 includes a housing 300, a main substrate 9, a cooling apparatus 102, and a plurality of modules. The main substrate 9, the cooling apparatus 102, and the plurality of modules are contained in the housing 300. The main substrate 9 and the plurality of modules are connected. Here, in the present example embodiment, the plurality of modules include modules 3A, 3B, 4A, 4B, 5A, 5B, 6A, 6B, and 8. For example, as shown in Fig. 5, the module 5A is disposed on the module 5B (in other words, in the +z-axis direction). Likewise, the modules 3A, 4A, and 6A are disposed on the modules 3B, 4B, and 6B (in the +z-axis direction), respectively. The modules 3A, 4A, 5A, 6A, and 8 are connected via a plurality of flexible pipes. In the present example embodiment, a configuration including the modules 3A, 4A, 5A, 6A, and 8 is referred to as an upper configuration of the electronic device 1000. In addition, a configuration including the modules 3B, 4B, 5B, and 6B is referred to as a lower configuration of the electronic device 1000. In the present example embodiment, the modules 3A, 3B may be collectively referred to as a module 3. Not limited to this example, configurations given with symbols including the same number plus different alphabets will be collectively referred to without the alphabets.

The modules 3, 4, 5, 6, and 8 have the same configuration as the modules 1, 2. In other words, each of the modules 3, 4, 5, 6, and 8 includes at least an electronic circuit board including a heat-generating member, and a cooling member. In addition, in the example of Fig. 5, the module 3 is installed in such a way that the cooling member 32 is directed in the +z-axis direction. Similarly, the modules 6, 8 are installed in such a way that the cooling member is directed in the +z-axis direction. In contrast, the modules 4, 5 are installed in such a way that the cooling member is directed in the -z-axis direction. The installation direction of each module is not limited to this example. For example, each module may be installed in such a way that the cooling member of each module is directed in the +z-axis direction.

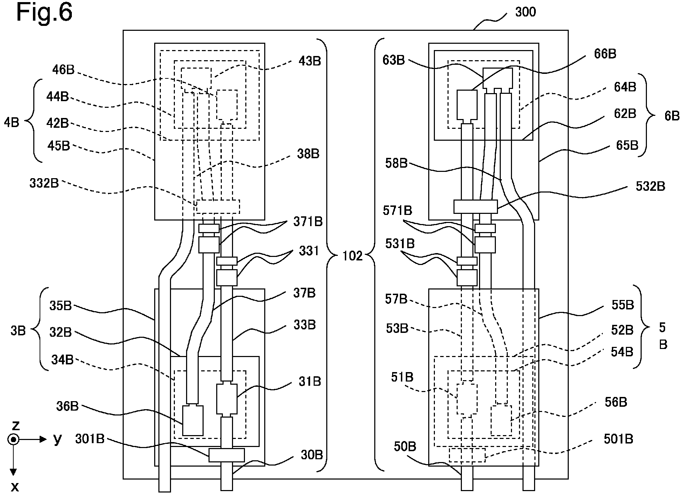

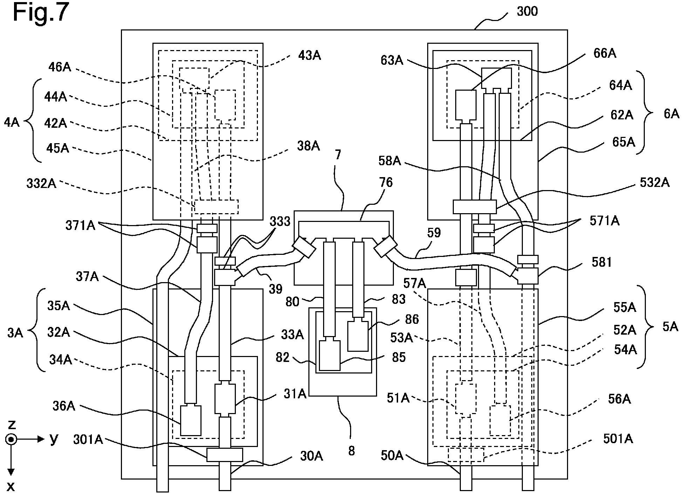

With reference to Fig. 6 and 7, a configuration of the electronic device 1000 will now be described. Fig. 6 is a plan view illustrating an example of the lower configuration of the electronic device 1000. In addition, Fig. 7 is a plan view illustrating an example of the upper configuration of the electronic device 1000. Fig. 6 and Fig. 7 are each a plan view from a viewpoint in the +z-axis direction in Fig. 5.

The cooling apparatus 102 includes first flexible pipes 30, 50, branching members 31, 51, second flexible pipes 33, 53, third flexible pipes 37, 57, fourth flexible pipes 38, 58, and joining members 43, 63. The first flexible pipes 30, 50, branching members 31, 51, second flexible pipes 33, 53, third flexible pipes 37, 57, fourth flexible pipes 38, 58, and joining members 43, 63 has the same function as the first flexible pipe 10, branching member 11, second flexible pipe 13, third flexible pipe 17, fourth flexible pipe 18, and the joining member 23, respectively. In other words, the first flexible pipes 30, 50 are each supplied with the heat medium from a pump or radiator or the like outside the housing 300. In addition, the fourth flexible pipes 38, 58 each discharge the heat medium passing through the module to a radiator or the like outside the housing 300.

The first flexible pipes 30, 50 are fixed on the electronic circuit boards 35, 55 by fixing members 301, 501, respectively. Similarly, the second flexible pipe 33 and third flexible pipe 37 are fixed on an electronic circuit board 45 by a fixing member 332, and the second flexible pipe 53 and third flexible pipe 57 are fixed on the electronic circuit board 55 by a fixing member 532.

With reference to Fig. 6, details of the lower configuration of the electronic device 1000 will now be described. In the lower configuration, the second flexible pipes 33B, 53B include two flexible pipes connected by coupling members 331, 531B, respectively. The coupling member is a member for connecting two flexible pipes. Although in the example of Fig. 6, two flexible pipes are connected, three or more flexible pipes may be connected in series using two or more coupling members. As described above, the second flexible pipe includes a plurality of flexible pipes connected in series by the coupling member. Thus, a pipe may be installed whose length is adjusted according to the size of the housing 300 and the arrangement of the modules. In addition, the coupling member may facilitate detachment of the flexible pipe. Similarly, the third flexible pipes 37, 57 include two flexible pipes connected by coupling members 371, 571, respectively.

A path through which the heat medium passes in the lower configuration of the electronic device 1000 will be described. First, a path of the heat medium passing through the module 3B, 4B will be described. The first flexible pipe 30B supplies the heat medium supplied from a pump or radiator or the like outside the housing 300 to the branching member 31B. The branching member 31B causes the heat medium to branch into the cooling member 32B and second flexible pipe 33B. The heat medium flowing through the cooling member 32B receives heat from the heat-generating member 34B and cooling member 32B, passes through the connection joint 36B and third flexible pipe 37B, and flows into the joining member 43B. In addition, the heat medium supplied from the branching member 31B to the second flexible pipe 33B passes through the connection joint 46B, and flows into the cooling member 42B. The heat medium flowing through the cooling member 42B receives heat from the heat-generating member 44 and cooling member 22, and flows into the joining member 43B. Then, the heat medium flows into the fourth flexible pipe 38B from the joining member 43B. The fourth flexible pipe 38B is connected to, for example, a radiator or the like outside the housing 300. In other words, the heat medium that receives heat in the housing 300 passes through the fourth flexible pipe 38B, and is cooled by a radiator or the like. The cooled heat medium is supplied again to the first flexible pipe 30B. The path of the heat medium passing through the modules 5B, 6B is the same as the path of the heat medium passing through the modules 3B, 4B described above.

Details of the lower configuration of the electronic device 1000 will now be described. As shown in Fig. 7, a second flexible pipe 33A is connected to a fifth flexible pipe 39 by a branching fitting member 333. When the heat medium flows in from the branching member 31A, the second flexible pipe 33A causes the heat medium to branch in the direction of the connection joint 46A and the direction of the fifth flexible pipe 39. As described above, the second flexible pipe is also connected to another flexible pipe by the branching fitting member, and causes the heat medium flowing in from the branching member to branch into the second flexible pipe and the another flexible pipe. In addition, the fourth flexible pipe 58A is connected to an eighth flexible pipe 59 by a branching fitting member 581. The fourth flexible pipe 58Ajoins the heat medium flowing in from the eighth flexible pipe 59 and the heat medium flowing in from the joining member 63A.

A path through which the heat medium passes in the lower configuration of the electronic device 1000 will be described. The path through the modules 3A, 4A and modules 5A, 6A is the same as the path through the modules 3B, 4B and modules 5B, 6B described above. Therefore, the description of the path through the modules 3A, 4A and modules 5A, 6A will be omitted.

The fifth flexible pipe 39 is connected to a connection joint 76 of a hood member 7. The heat medium branched in the branching fitting member 333 passes through the fifth flexible pipe 39 and flows into the connection joint 76. The heat medium flowing in from the fifth flexible pipe 39 flows into a sixth flexible pipe 80 from the connection joint 76. The heat medium passes through the connection joint 85 from the sixth flexible pipe 80 and is supplied to the cooling member 82. The heat medium that passes through the cooling member 82 passes through a connection joint 86 and a seventh flexible pipe 83 and flows into the connection joint 76. The heat medium flowing in from the seventh flexible pipe 83 adds the eighth flexible pipe 59 from the connection joint 76 and flows into the branching fitting member 581.

As described above, the cooling apparatus 102 of the third example embodiment connects pipes using the branching member and the branching fitting member, and supplies the heat medium to each cooling member. Therefore, the increase in the number of pipes may be suppressed. In addition, also in the third example embodiment, the heat medium supplied to each cooling member in the housing 300 is a heat medium not directly affected by heat generation by the heat-generating member. In other words, a heat medium with suppressed temperature rise is supplied to each cooling member. As described above, the cooling apparatus 102 may efficiently cool the heat-generating member while suppressing the increase in the number of pipes.

While the invention has been particularly shown and described with reference to exemplary embodiments thereof, the invention is not limited to these embodiments It will be understood by those of ordinary skill in the art that various changes in form and details may be made therein without departing from the spirit and scope of the present invention as defined by the claims.

This application is based upon and claims the benefit of priority from Japanese patent application No. 2021-078894 filed on May 7, 2021, the disclosure of which is incorporated herein in its entirety by reference.

### Reference Signs List

1, 2, 3, 4, 5, 6, 8 module
10, 30, 50 first flexible pipe
11, 31, 51 branching member
12, 22, 32, 42, 52, 62, 82 cooling member
13, 33, 53 second flexible pipe
14, 24, 34, 44, 54, 64 heat-generating member
15, 25, 35, 45, 55, 65 electronic circuit board
17, 37, 47 third flexible pipe
18, 38, 58 fourth flexible pipe
23, 43, 63 joining member
331, 371, 531, 571 coupling member
333, 581 branching fitting member
100, 101, 102 cooling apparatus
200, 300 housing
1000 electronic device

## Claims

1. A cooling apparatus comprising:
a first flexible pipe at least a part of which is arranged inside a housing and through which a heat medium supplied from an outside of the housing passes, the housing including a plurality of modules installed in the housing, each of the plurality of modules including an electronic circuit board including a heat-generating member and a cooling member that receives heat from the heat-generating member and cools the heat-generating member by using the heat medium; and
a branching member that causes the heat medium to branch from the first flexible pipe into the cooling member and a second flexible pipe, the cooling member being included in any one of the plurality of modules, the second flexible pipe supplying the heat medium to the cooling member included in any other module of the plurality of modules,
wherein the branching member is provided together with the cooling member.

2. The cooling apparatus according to claim 1,
wherein the first flexible pipe has a pipe diameter larger than a pipe diameter of the second flexible pipe.

3. The cooling apparatus according to claim 1 or 2, further comprising:
the second flexible pipe; and
a joining member that joins the heat medium discharged from a first cooling member and the heat medium discharged from a second cooling member, the first cooling member being the cooling member provided together with the branching member, the second cooling member being the cooling member included in the other module.

4. The cooling apparatus according to claim 3,
wherein the joining member joins the heat medium flowing in from a third flexible pipe and the heat medium discharged from the second cooling member, the third flexible pipe being provided together with the second cooling member, the heat medium discharged from the first cooling member passing through the third flexible pipe.

5. The cooling apparatus according to claim 3,
wherein the joining member joins the heat medium flowing in from a third flexible pipe and the heat medium discharged from the first cooling member, the third flexible pipe being provided together with the first cooling member, the heat medium discharged from the second cooling member passing through the third flexible pipe.

6. The cooling apparatus according to any of claims 1 to 5,
wherein the second flexible pipe comprises a plurality of flexible pipes connected in series by a coupling member.

7. The cooling apparatus according to any of claims 1 to 6,
wherein the second flexible pipe is further connected to another flexible pipe by a branching fitting member, and causes the heat medium flowing in from the branching member to branch into the second flexible pipe and the another flexible pipe.
